# EUROPÄISCHE PATENTSCHRIFT

(11) **EP 1 430 758 B1**
(45) Veröffentlichungstag und Bekanntmachung des Hinweises auf die Patenterteilung: **09.08.2006**
(21) Anmeldenummer: 02772075.4
(22) Anmeldetag: 19.09.2002
(51) Int. Cl.: H05K 7/20

(54) **ELEKTRISCHE SCHALTUNGSANORDNUNG AUS MEHREREN ELEKTRISCH MITEINANDER VERBUNDENEN SCHALTUNGSBAUTEILEN**
ELECTRICAL CIRCUIT ARRANGEMENT COMPRISED OF A NUMBER OF ELECTRICALLY INTERCONNECTED CIRCUIT COMPONENTS
MONTAGE ELECTRIQUE COMPOSE DE PLUSIEURS COMPOSANTS DE CIRCUITS CONNECTES ELECTRIQUEMENT

(30) Priorität: 27.09.2001 DE 10147758
(43) Veröffentlichungstag der Anmeldung: 23.06.2004
(73) Patentinhaber: SIEMENS AKTIENGESELLSCHAFT, 80333 München (DE)
(72) Erfinder: OTTO, Johann, 83646 Bad Tölz (DE); HONSBERG-RIEDL, Martin, 83454 Anger (DE)
(86) Internationale Anmeldenummer: PCT/DE2002/003520
(87) Internationale Veröffentlichungsnummer: WO 2003/030607

(56) Entgegenhaltungen:
- GB-A- 2 126 802
- US-A- 4 928 206
- US-B1- 6 175 501

## Beschreibung

Die Erfindung betrifft eine elektrische Schaltungsanordnung aus mehreren Schaltungsbauteilen, die elektrisch miteinander verbunden sind.

Bei bekannten derartigen Schaltungsanordnungen ist jedes Schaltungsbauteil, sei es passiv oder aktiv, an eine Leiterbahn einer starren Leiterbahnplatine angeschlossen und an dieser Platine befestigt, so dass die Platine zugleich einen Träger für die Schaltungsbauteile bildet.

Beispiele solcher Schaltungsanordnungen sind leistungselektronische Schaltungsmodule geringer Leistung, darunter elektronische Lampenvorschaltgeräte für elektrische Lampen aller Art.

Solche Module beinhalten viele sehr kleine und einige große Schaltungsbauteile. Die Ausmaße eines solchen Moduls sind durch die Nebeneinanderanordnung der großen Schaltungsbauteile auf der starren Leiterbahnplatine bestimmt und damit ziemlich groß. Eine Verkleinerung der Module wird durch Nebenplatinen oder Sondermontage großer, sperriger Bauteile erreicht

Da heute bei leistungselektronischen Schaltungen geringer Leistung die spezifische Verlustleistung der Schaltungsbauteile und deren Packungsdichte jeweils so gering gehalten ist, dass zur Kühlung eine nur schwache Kopplung der Schaltungsbauteile an eine Wärmesenke über Luft oder Silikongel ausreicht, werden lediglich bestimmte aktive Schaltungsbauteile, z.B. Schalthalbleiter, gelegentlich beispielsweise durch eine Montage an lokale Wärmesenken besser gekühlt.

Eine elektrische Schaltungsanordnung nach dem Oberbegriff des Anspruchs 1 ist aus der US 4 928 206 oder der GB 2 126 802 bekannt.

Aufgabe der Erfindung ist es, eine baulich kompakte elektrische Schaltungsanordnung der genannten Art bereitzustellen, die relativ klein ist und bei der zugleich alle Bauelemente, einschließlich der passiven, gleich gut gekühlt werden.

Diese Aufgabe wird durch eine elektrische Schaltungsanordnung gelöst, welche die im Anspruch 1 angegebenen Merkmale aufweist.

Demgemäss ist bei der erfindungsgemäßen elektrischen Schaltungsanordnung aus mehreren Schaltungsbauteilen, die elektrisch miteinander verbunden sind,
- jedes Schaltungsbauteil elektrisch an eine Leiterbahn eines flexiblen Leiterbahnträgers angeschlossen,
- ist der flexible Leiterbahnträger in einer gefalteten Konfiguration zusammen mit den daran angeschlossenen Schaltungsbauteilen in einem Innenraum eines flüssigkeitsdichten Gehäuses angeordnet, und
- ist der Innenraum des Gehäuses mit einer elektrisch nicht leitenden Kühlflüssigkeit gefüllt, die mit allen Schaltungsbauteilen in Kontakt steht.
- ist eine Einrichtung zum Umwälzen der Kühlflüssigkeit im Innenraum des Gehäuses vorhanden, so dass die Kühlflüssigkeit an den Schaltungsbauteilen vorbeibewegt wird.

Durch die Verwendung des flexiblen Leiterbahnträgers können vorteilhafterweise die an diesen angeschlossenen Schaltungsbauteile durch geeignetes Falten oder Umbiegen des flächenhaften Leiterbahnträgers enger beieinander angeordnet und in dieser dichteren Packung in einem Innenraum eines Gehäuses untergebracht werden, wobei dieser Innenraum der dichteren Packung angepasst ist und der Geometrie dieser Packung entsprechend kompliziert geformt sein kann. Dadurch ist vorteilhafterweise die erfindungsgemäße Schaltungsanordnung baulich kompakt.

Der noch ungefaltete plane flexible Leiterbahnträger kann vorteilhafterweise automatisch und somit kostengünstig mit den an ihn anzuschließenden Schaltungsbauteilen bestückt werden.

Die Verwendung des flüssigkeitsdichten Gehäuses ermöglicht vorteilhafterweise das dauerhafte Füllen des Innenraums des Gehäuses mit einer Kühlflüssigkeit, die mit jedem der dichter gepackten Schaltungsbauteile in Kontakt steht und jedes dieser Bauteile gleich stark kühlen kann.

Eine besonders effiziente Kühlung aller Schaltungsbauteile der erfindungsgemäßen Schaltungsanordnung kann erreicht werden, wenn die Kühlflüssigkeit nicht nur durch Wärmekonvektion bewegt, sondern aktiv im Innenraum des Gehäuses umgewälzt wird.

Zu diesem Zweck weist eine vorteilhafte Ausgestaltung der erfindungsgemäßen Schaltungsanordnung eine Einrichtung zum Umwälzen der Kühlflüssigkeit im Innenraum des Gehäuses, so dass die Kühlflüssigkeit ständig an den Schaltungsbauteilen vorbeibewegt wird, auf. Durch eine solche Einrichtung kann vorteilhafterweise die Temperatur aller Schaltungsbauteile gleich gehalten werden.

Eine Wärmesenke zur Kühlung der erwärmten Kühlflüssigkeit und Bewirken der Konvektion kann außen an das Gehäuse montiert sein. An diese kühlende Wärmesenke sind vorteilhafterweise alle Schaltungsbauteile, also nicht nur die aktiven, sondern auch die passiven Schaltungsbauteile und der Leiterbahnträger der erfindungsgemäßen Schaltungsanordnung stark gekoppelt. Es werden vorteilhafterweise alle Schaltungsbauteile thermisch erreicht, also auch kompliziert geformte, wie es z.B. Induktivitäten sind.

Zur Erleichterung der Bewegung der Kühlflüssigkeit im Innenraum des Gehäuses weist der flexible Leiterbahnträger vorzugs- und vorteilhafterweise eine oder mehrere durchgehende Öffnungen aufweist, durch die sich die Kühlflüssigkeit von einer Flachseite zur anderen Flachseite des Leiterbahnträgers bewegen kann.

Vorzugsweise weist die Einrichtung zum Umwälzen der Kühlflüssigkeit eine Umwälzpumpe auf, die vorzugs- und vorteilhafterweise in einem parallel zum Innenraum des Gehäuses geschalteten Kanal für die Kühlflüssigkeit angeordnet ist, durch welchen Kanal die Umwälzpumpe die Kühlflüssigkeit einerseits aus dem Innenraum des Gehäuses abführt und andererseits diesem Innenraum wieder zuführt. Der Kanal und die Umwälzpumpe können vorteilhafterweise im Gehäuse angeordnet sein.

Ein bevorzugte und vorteilhafte Ausgestaltung einer derart angeordneten Umwälzpumpe weist
- eine im Kanal angeordnete und in einer Längsrichtung des Kanals ausgerichtete Lamelle und
- eine Betätigungseinrichtung zu einem flossenartigen Hin- und Herbewegen der Lamelle senkrecht zur Längsrichtung des Kanals auf. Eine solche Lammelle ermöglicht vorteilhafterweise einen flachen Querschnitt des Kanals.

Die Betätigungseinrichtung weist vorzugs- und vorteilhafterweise einen Piezoaktor auf. Piezoaktoren sind aus den Gesichtspunkten der Einfachheit, des Wirkungsgrades und der Lebensdauer gut geeignet. Insbesondere ist ein Piezoaktor für einen Kanal mit flachem Querschnitt geeignet.

Die Kühlflüssigkeit weist vorzugsweise ein Öl auf.

Eine Leiterbahn des Leiterbahnträgers kann mit dem Außenraum des Gehäuses verbunden werden, wenn diese Leiterbahn elektrisch mit einem flüssigkeitsdicht durch eine Wandung des Gehäuses geführten äußeren elektrischen Anschluss des Gehäuses verbunden ist.

Eine bevorzugte Ausführungsform der erfindungsgemäßen Schaltungsanordnung ist ein Lampenvorschaltgerät für elektrische Lampen aller Art, d.h. die Schaltungsbauteile dieser Schaltungsanordnung sind die eines solchen Lampenvorschaltgeräts, die auf dem flexiblen Leiterbahnträger entsprechend einem solchen Gerät verschaltet sind. Äußere Anschlüsse des Geräts sind durch Anschlüsse des Gehäuses der Schaltungsanordnung realisiert.

Bei der erfindungsgemäßen Schaltungsanordnung führt die Verbindung einer effizienten Temperaturhomogenisierung einer komplizierten Schaltungsgeometrie mit den Vorteilen eines flexiblen Leiterbahnträgers vorteilhafterweise generell zu einer deutlichen baulichen Verkleinerung von leistungselektronischen Modulen kleiner Leistung.

Die Erfindung wird in der nachfolgenden Beschreibung anhand der Zeichnungen beispielhaft näher erläutert. Es zeigen:
- Figur 1: einen vertikalen Längsschnitt durch das Gehäuse einer beispielhaften erfindungsgemäßen Schaltungsanordnung, wobei die Schaltungsbauteile und der gefaltete Leiterbahnträger im Innenraum ungeschnitten in Seitenansicht gezeigt sind, und
- Figur 2: einen horizontalen Längsschnitt durch das Gehäuse der Schaltungsanordnung nach Figur 1 längs der Schnittlinie II-II in Figur 1, wobei die Schaltungsbauteile und der bruchstückhaft dargestellte gefaltete Leiterbahnträger im Innenraum ungeschnitten in Draufsicht gezeigt sind.

Bei der in den Figuren dargestellten beispielhaften elektrischen Schaltungsanordnung aus mehreren Schaltungsbauteilen, die elektrisch miteinander verbunden sind, sind die Schaltungsbauteile mit 1 bis 5, der flexible Leiterbahnträger mit 6, das flüssigkeitsdichte Gehäuse mit 7 und die Kühlflüssigkeit mit 8 bezeichnet.

Die beispielhafte Schaltungsanordnung ist speziell ein Lampenvorschaltgerät für elektrische Lampen aller Art, darunter Glühlampen, Entladungslampen und Leuchtstofflampen. Die erfindungsgemäße Schaltungsanordnung ist aber nicht auf Lampenvorschaltgeräte beschränkt, sondern kann jede beliebige Schaltungsanordnung aus mehreren Schaltungsbauteilen, die elektrisch miteinander verbunden sind, sein

Bei der dargestellten Schaltungsanordnung in Form des Lampenvorschaltgeräts ist speziell das Schaltungsbauteil 1 ein Schalthalbleiter, das Schaltungsbauteil 2 ein Transformator, das Schaltungsbauteil 3 ein großer Kondensator und das Schaltungsbauteil 4 eine Drosselspule. Diese Schaltungsbauteile 1 bis 4 sind große, sperrige Bauteile.

Die mehreren Schaltungsbauteile 5 sind Kleinbauteile in Form von Widerständen, kleinen Kondensatoren, Halbleiterdioden, Transistoren usw.

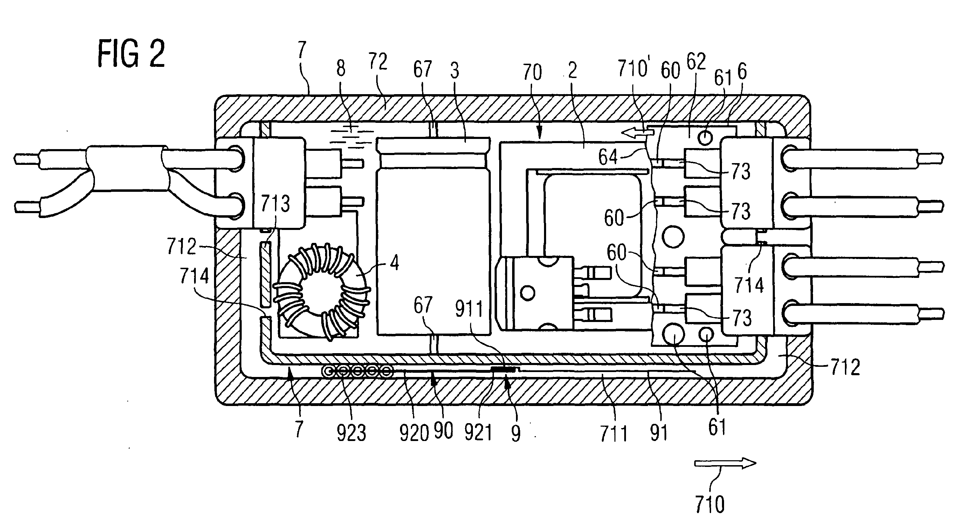

Jedes der Schaltungsbauteile 1 bis 5 ist elektrisch an eine Leiterbahn 60 (siehe Figur 2) eines flexiblen Leiterbahnträgers 6 angeschlossen.

Der flexible Leiterbahnträger 6 ist in einer gefalteten Konfiguration zusammen mit den daran angeschlossenen Schaltungsbauteilen 1 bis 5 in einem Innenraum 70 des flüssigkeitsdichten Gehäuses 7 angeordnet. Durch die Faltung des Leiterbahnträgers 6 sind die großen sperrigen Schaltungsbauteile 1 bis 4 eng beieinander angeordnet und der Leiterbahnträger 6 selbst hat relativ zu seiner ursprünglichen planen Form kleinere Abmessungen. Dadurch sind die Schaltungsbauteile 1 bis 5 dichter gepackt und die ganze Schaltung der Schaltungsanordnung ist baulich kompakter.

Vorzugsweise sind die mit dem Leiterbahnträger 6 elektrisch verbundenen größeren Schaltungsbauteile 1 bis 4 im Innenraum 70 des Gehäuses 7 zur Erhöhung der Stabilität der Schaltungsanordnung jeweils am Gehäuse 7 befestigt, beispielsweise mittels eines Klebstoffs 75.

Der Innenraum 70 des Gehäuses 7 ist mit der elektrisch nicht leitenden Kühlflüssigkeit 8 gefüllt, die mit allen Schaltungsbauteilen 1 bis 5 in Kontakt steht. Eine nicht dargestellte Wärmesenke zur Kühlung der durch die Schaltungsbauteile 1 bis 5 erwärmten Kühlflüssigkeit 8 und Bewirken der Konvektion der Kühlflüssigkeit 8 kann außen an das Gehäuse 7 montiert sein. An diese kühlende Wärmesenke sind alle Schaltungsbauteile 1 bis 5 und der Leiterbahnträger 6 stark gekoppelt. Es werden alle Schaltungsbauteile 1 bis 5 thermisch erreicht.

Zur Erleichterung der Bewegung der Kühlflüssigkeit 8 im Innenraum 70 des Gehäuses 7 weist der flexible Leiterbahnträger 6 mehrere durchgehende Öffnungen 61 auf, durch die sich die Kühlflüssigkeit 8 von einer Flachseite 62 zur anderen Flachseite 62 des Leiterbahnträgers 6 bewegen kann.

Zur Erzielung einer besonders effizienten Kühlung aller Schaltungsbauteile 1 bis 5 weist die Schaltungsanordnung eine in Figur 2 gezeigte Einrichtung 9 zum Umwälzen der Kühlflüssigkeit 8 im Innenraum 70 des Gehäuses 7, so dass die Kühlflüssigkeit 8 an den Schaltungsbauteilen 1 bis 5 vorbeibewegt wird, auf. Die Kühlflüssigkeit 8 wird hier nicht nur durch Wärmekonvektion bewegt, sondern aktiv im Innenraum 70 des Gehäuses 7 umgewälzt.

Die Einrichtung 9 zum Umwälzen der Kühlflüssigkeit 8 weist eine Umwälzpumpe 90 auf, die speziell in einem parallel zum Innenraum 70 des Gehäuses 7 geschalteten Kanal 71 für die Kühlflüssigkeit 8 angeordnet ist und die insbesondere eine im Kanal 71 angeordnete Lamelle 91 und eine Betätigungseinrichtung 92 zu einem flossenartigen Hin- und Herbewegen der Lamelle 91 senkrecht zu einer Längsrichtung 710 des Kanals 71 aufweist.

Die Lammelle 91 ist beispielsweise in einem geradlinig verlaufenden Mittelabschnitt 711 des Kanals 71 in der Längsrichtung 710 des Kanals 71 angeordnet. Nach Figur 2 verläuft dieser Mittelabschnitt 711 speziell auf einer Seite des Gehäuses 7 in der zur Zeichenebene der Figur 2 parallelen Längsrichtung 710 des Kanals 71 und erstreckt sich sowohl in dieser Längsrichtung 710 als auch in Richtung senkrecht zur Zeichenebene der Figur 2 jeweils im Wesentlichen über die ganze Abmessung des Innenraums 70 des Gehäuses 7.

Die Betätigungseinrichtung 92 weist vorzugsweise einen Piezoaktor 920 auf, der ebenfalls lamellenartig ausgebildet ist. Der Piezoaktor 920 ist im geraden Mittelabschnitt 711 des Kanals 71 in der gleichen zur Zeichenebene der Figur 2 senkrechten Ebene wie die Lamelle 91 angeordnet und fest mit der Lamelle 91 verbunden, beispielsweise dadurch, dass ein Endabschnitt 911 der Lamelle 91 und ein diesem Endabschnitt 911 zugekehrter Endabschnitt 921 des Piezoaktors 920 aufeinander gelegt und fest miteinander verbunden sind.

Die Anordnung von Piezoaktor 920 und Lamelle 91 ist gemäß Figur 2 speziell so, dass in der Längsrichtung 710 des Kanals 71 die Lamelle 91 auf den Piezoaktor 920 folgt.

Ein von der Lamelle 91 abgekehrter Endabschnitt 922 des Piezoaktors 920 ist durch eine symbolisch durch kleine Ringe angedeutete Befestigungseinrichtung 923 unbeweglich fest mit dem Gehäuse 7 verbunden. Die Befestigungseinrichtung 923 ist so ausgebildet, dass sie den Durchfluss der Kühlflüssigkeit 8 durch den Kanal 71 gewährleistet. Zugleich ist es zweckmäßig, wenn die Befestigungseinrichtung 923 elektrische Zuleitungen für den Betrieb des Piezoaktors 920 aufweist.

Beim Betrieb schwingt der Endabschnitt 921 des Piezoaktors 920 in der Zeichenebene der Figur 2 senkrecht zur Längsrichtung 710 des Kanals 71 hin- und her und erteilt der Lamelle 91 eine der Bewegung einer Schwanzflosse eines Fisches ähnelnde flossenartige Hin- und Herbewegung parallel zur Zeichenebene der Figur 2 und senkrecht zur Längsrichtung 710 des Kanals 71. Dadurch wird bei der speziellen Anordnung von Piezoaktor 920 und Lamelle 91 bewirkt, dass die Kühlflüssigkeit 8 von einer den Kanal 71 mit dem Innenraum 70 verbindenden Öffnung 713 auf der Seite des Piezoaktors 920 in der Längsrichtung 710 des Kanals 71 durch den Mittelabschnitt 711 des Kanals 71 zu einer den Kanal 71 mit dem Innenraum 70 verbindenden Öffnung 714 auf der Seite der Lamelle 91 strömt.

Dies bewirkt wiederum, dass die Kühlflüssigkeit 8 im Innenraum 70 des Gehäuses 7 in der zur bezeichneten Längsrichtung 710 des Kanals 71 entgegengesetzten Richtung 710' umgewälzt wird, und dabei ständig an jedem der Schaltungsbauelemente 1 bis 5 und dem Leiterbahnträger 6 vorbei und durch die Öffnungen 61 des Leiterbahnträgers 6 strömt.

Speziell ist der Kanal 71 so ausgebildet, dass er neben dem geraden Mittelabschnitt 711 zwei auf jeder Seite der Anordnung von Piezoaktor 920 und Lamelle 91 an den Mittelabschnitt 711 grenzende Endabschnitte 712 aufweist, deren jeder sich sowohl in einer zur bezeichneten Längsrichtung 710 des Kanals 71 als auch in Richtung senkrecht zur Zeichenebene der Figur 2 jeweils im Wesentlichen über die ganze Abmessung des Innenraums 70 des Gehäuses 7 erstreckt.

Jeder dieser Endabschnitte 712 weist auf seiner dem Innenraum 70 des Gehäuses 7 zugekehrten Seite mehrere der Öffnungen 714 auf, deren jede den Kanal 71 mit dem Innenraum 70 verbindet. Jede dieser Öffnungen 714 kann beispielsweise schlitzartig so ausgebildet sein, dass sie sich in Richtung senkrecht zur Zeichenebene der Figur 2 im Wesentlichen über die ganze Abmessung des Innenraums 70 des Gehäuses 7 erstreckt.

Der ganze Kanal 71 ist vorzugsweise in das Gehäuse 7 integriert und verläuft beispielsweise im Innern des Gehäuses 7 entlang einer Wandung 72 des Gehäuses 7.

Die Kühlflüssigkeit 8 ist vorzugsweise ein Kühlöl.

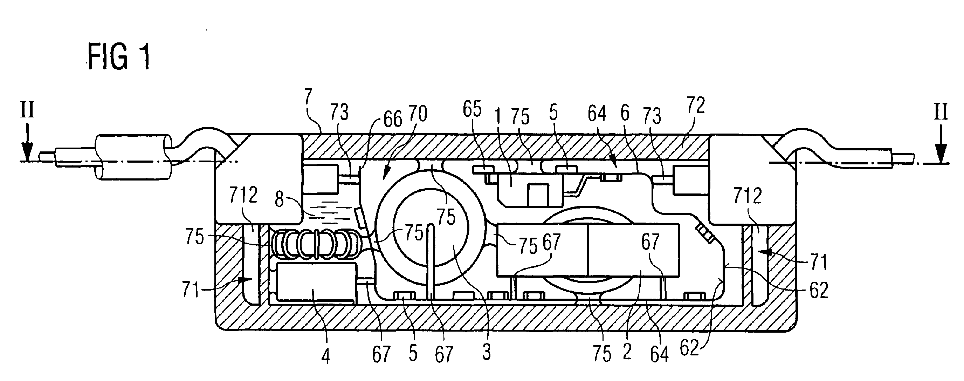

Während in der Figur 1 eine sich über die ganze Länge des Leiterbahnträger 6 erstreckende schmale Längskante 63 des Leiterbahnträgers 6 zu sehen ist, ist in der Figur 2 ein von der Stelle 64 des Leiterbahnträgers 6 bis zu dem beim Schaltungsbauteil 1 liegenden Ende 65 des Leiterbahnträgers 6 reichender Endabschnitt des Leiterbahnträgers 6 fortgebrochen und eine Flachseite 62 nur eines bei der Stelle 64 beginnenden Stücks Leiterbahnträger 6 in Draufsicht dargestellt.

Auf dieser Flachseite 62 sind beispielsweise mehrere beispielsweise vier Leiterbahnen 60 des Leiterbahnträgers 6 elektrisch mit je einem von ebenfalls vier flüssigkeitsdicht durch die Wandung 72 des Gehäuses 7 geführten äußeren elektrischen Anschluss 73 des Gehäuses 7 verbunden ist. Auf der anderen Seite des Gehäuses 7 sind beispielsweise zwei flüssigkeitsdicht durch die Wandung 72 des Gehäuses 7 geführte äußere elektrische Anschlusse 73 des Gehäuses 7 mit je einer Leiterbahn 60 des in der Figur 2 dort nicht dargestellten, aber nach Figur 1 dort ein Ende 66 aufweisenden Leiterbahnträgers 6 verbunden.

Bei der Schaltungsanordnung in Form eines Lampenvorschaltgeräts für elektrische Lampen sind beispielsweise die vier Anschlüsse 73 auf der rechten Seite des Gehäuses 7 zum Anschluss an die Lampen und die zwei Anschlüsse 73 auf der linken Seite des Gehäuses 7 zum Anschluss an das Netz vorgesehen.

Elektrische Verbindungen zwischen einer Leiterbahn 60 des Leiterbahnträgers 6 und einem großen Schaltungsbauteil 2, 3 und 4 sind in den Figuren mit 67 bezeichnet.

## Patentansprüche

1. Elektrische Schaltungsanordnung aus mehreren Schaltungsbauteilen (1 - 5), die elektrisch miteinander verbunden sind, wobei
- jedes Schaltungsbauteil (1 - 5) elektrisch an eine Leiterbahn (60) eines flexiblen Leiterbahnträgers (6) angeschlossen ist, wobei
- der flexible Leiterbahnträger (6) in einer gefalteten Konfiguration zusammen mit den daran angeschlossenen Schaltungsbauteilen (1 - 5) in einem Innenraum (70) eines flüssigkeitsdichten Gehäuses (7) angeordnet ist, und wobei
- der Innenraum (70) des Gehäuses (7) mit einer elektrisch nicht leitenden Kühlflüssigkeit (8) gefüllt ist, die mit allen Schaltungsbauteilen (1 - 5) in Kontakt steht,
**dadurch gekennzeichnet, dass**
eine Einrichtung (9) zum Umwälzen der Kühlflüssigkeit (8) im Innenraum (70) des Gehäuses (7) vorhanden ist, so dass die Kühlflüssigkeit (8) an den Schaltungsbauteilen (1 - 5) vorbeibewegt wird.

2. Elektrische Schaltungsanordnung nach Anspruch 1, wobei der flexible Leiterbahnträger (6) eine oder mehrere durchgehende Öffnungen (61) aufweist.

3. Elektrische Schaltungsanordnung nach Anspruch 1 oder 2, wobei die Einrichtung (9) zum Umwälzen der Kühlflüssigkeit (8) eine Umwälzpumpe (90) aufweist.

4. Elektrische Schaltungsanordnung nach einem der Anspruch 3, wobei die Umwälzpumpe (90) in einem parallel zum Innenraum (70) des Gehäuses (7) geschalteten Kanal (71) für die Kühlflüssigkeit (8) angeordnet ist.

5. Elektrische Schaltungsanordnung nach Anspruch 4, wobei die Umwälzpumpe (90)
- eine im Kanal (71) angeordnete und in einer Längsrichtung (710) des Kanals (71) ausgerichtete Lamelle (91) und
- eine Betätigungseinrichtung (92) zu einem flossenartigen Hin- und Herbewegen der Lamelle (91) senkrecht zur Längsrichtung (710) des Kanals (71) aufweist.

6. Elektrische Schaltungsanordnung nach Anspruch 5, wobei die Betätigungseinrichtung (92) einen Piezoaktor (920) aufweist.

7. Elektrische Schaltungsanordnung nach einem der vorhergehenden Ansprüche, wobei die Kühlflüssigkeit (8) ein Öl aufweist.

8. Elektrische Schaltungsanordnung nach einem der vorhergehenden Ansprüche, wobei
wenigstens eine Leiterbahn (60) des Leiterbahnträgers (6) elektrisch mit zumindest einem flüssigkeitsdicht durch eine Wandung (72) des Gehäuses (7) geführten äußeren elektrischen Anschluss (73) des Gehäuses (7) verbunden ist.

9. Schaltungsanordnung nach einem der vorhergehenden Ansprüche in Form eines Lampenvorschaltgeräts für elektrische Lampen.

## Claims

1. An electrical circuit arrangement comprised of multiple circuit components (1-5) which are electrically interconnected, wherein
- each circuit component (1-5) is electrically connected to a conductor track (60) of a flexible conductor track support (6), wherein
- the flexible conductor track support (6) is arranged, together with the circuit components (1-5) connected thereto, in a folded configuration in an interior space (70) of a liquid-tight housing (7), and wherein
- the interior space (70) of the housing (7) is filled with a cooling liquid (8) which is not electrically conductive and is in contact with all circuit components (1-5),
**characterised in that**
a device (9) for circulating the cooling liquid (8) in the interior space (70) of the housing (7) is present, such that the cooling liquid (8) is moved past the circuit components (1-5).

2. An electrical circuit arrangement according to claim 1, wherein the flexible conductor track support (6) has one or more through openings (61).

3. An electrical circuit arrangement according to claim 1 or 2, wherein the device (9) for circulating the cooling liquid (8) has a circulating pump (90).

4. An electrical circuit arrangement according to one of [sic] claim 3, wherein the circulating pump (90) is arranged in a channel (71) for the cooling liquid (8), said channel being connected in parallel to the interior space (70) of the housing (7).

5. An electrical circuit arrangement according to claim 4, wherein the circulating pump (90)
- has a lamella (91) arranged in the channel (71) and oriented in a longitudinal direction (710) of the channel (71) and
- an actuation device (92) for moving the lamella (91) to and fro in a fin-like manner perpendicular to the longitudinal direction (710) of the channel (71).

6. An electrical circuit arrangement according to claim 5, wherein the actuation device (92) has a piezoactuator (920).

7. An electrical circuit arrangement according to any one of the preceding claims, wherein the cooling liquid (8) has an oil.

8. An electrical circuit arrangement according to any one of the preceding claims, wherein
at least one conductor track (60) of the conductor track support (6) is electrically connected to at least one external electrical terminal (73) of the housing (7) run liquid-tight through a wall (72) of the housing (7).

9. A circuit arrangement according to any one of the preceding claims in the form of a lamp ballast for electric lamps.

## Revendications

1. Montage électrique composé de plusieurs composants de circuit (1 - 5) qui sont raccordés entre eux électriquement,
- chaque composant de circuit (1 - 5) étant raccordé électriquement à une piste conductrice (60) d'un porteur (6) flexible de piste conductrice,
- le porteur (6) flexible de piste conductrice, dans une configuration pliée, étant disposé dans un espace intérieur (70) d'un boîtier (7) étanche aux liquides avec les composants de circuit (1 - 5) raccordés au porteur, et
- l'espace intérieur (70) du boîtier (7) étant rempli d'un liquide de refroidissement (8) électriquement non conducteur, qui est en contact avec tous les composants de circuit (1 - 5),
**caractérisé en ce qu'**
un dispositif (9) de circulation du liquide de refroidissement (8) dans l'espace intérieur (70) du boîtier (7) est présent, de sorte que le liquide de refroidissement (8) est déplacé en passant devant les composants de circuit (1 - 5).

2. Montage électrique selon la revendication 1, dans lequel le porteur (6) flexible de piste conductrice présente une ou plusieurs ouvertures (61) continues.

3. Montage électrique selon la revendication 1 ou 2, dans lequel le dispositif (9) de circulation du liquide de refroidissement (8) présente une pompe de circulation (90).

4. Montage électrique selon la revendication 3, dans lequel la pompe de circulation (90) est disposée dans un canal (71) de liquide de refroidissement (8) mis en parallèle à l'espace intérieur (70) du boîtier (7).

5. Montage électrique selon la revendication 4, dans lequel la pompe de circulation (90) présente
- une lamelle (91) disposée dans le canal (71) et dirigée dans une direction longitudinale (710) du canal (71) et
- un dispositif de commande (92) pour un mouvement d'aller et vient de la lamelle (92), semblable à un aileron, perpendiculairement à la direction longitudinale (710) du canal (71).

6. Montage électrique selon la revendication 5, dans lequel le dispositif de commande (92) présente un acteur piézoélectrique (920).

7. Montage électrique selon l'une quelconque des revendications précédentes, dans lequel le liquide de refroidissement (8) présente une huile.

8. Montage électrique selon l'une quelconque des revendications précédentes,
dans lequel au moins une piste conductrice (60) du porteur (6) de piste conductrice est raccordée électriquement à au moins un raccord électrique externe (73) du boîtier (7), mené à travers une paroi (72) du boîtier (7) de manière étanche aux liquides.

9. Montage selon l'une quelconque des revendications précédentes sous forme d'un ballast de lampe pour lampes électriques.
